# EUROPEAN PATENT APPLICATION

(11) **EP 4 170 064 A1**
(43) Date of publication of application: **26.04.2023**
(21) Application number: 21203745.1
(22) Date of filing: 20.10.2021
(51) Int. Cl.: C23C 28/04, C23C 28/00, C23C 30/00, C23C 14/06, C23C 14/32, C23C 14/34

(54) **COATED CUTTING TOOL**

(71) Applicant: AB Sandvik Coromant, 811 81 Sandviken (SE)
(72) Inventor: JOHNSON, Lars, 811 81 Sandviken (SE); Saraiva, Marta, 811 81 Sandviken (SE)
(74) Representative: Sandvik

(57) **Abstract**

The present invention relates to a nano layered coating comprising alternating first and second layer stacks wherein the average layer period thickness in the first and second layer stacks are different from each other. The nano layered coating shows an improved edge line toughness and an improved resistance against flank wear and comb cracks.

## Description

### Background

Nano-multilayered coatings are commonly used in the area of cutting tools for metal machining. In these coatings at least two layers, which are different in some respect, alternate and form a coating of nanolayers.

Metal machining operations include, for example, turning, milling, and drilling.

In order to provide a long tool life a coated cutting tool, such as an insert, should have high resistance against different types of wear, e.g., flank wear resistance, crater wear resistance, chipping resistance and flaking resistance.

Different metal machining operations affect a coated cutting tool in different ways. Turning, for example, is a continuous metal machining operation while milling is more intermittent in nature. In milling the thermal and mechanical load will vary over time.

There is a continuing demand for coated cutting tools in which the coating has excellent properties in terms of flank wear resistance, crater wear resistance, edge line toughness, comb crack resistance, flaking resistance, etc. in order to provide a cutting tool with superior properties than currently available cutting tools on the market. If one or more of the above-mentioned properties are improved then longer tool life is provided.

EP2883637 discloses a nanolayer coating with alternating layer stacks, where a first layer stack having an average layer period thickness of 60-500 nm is alternated with a second layer stack having an average layer period thickness of 2-60 nm.

There is an object of the present invention to provide a coated cutting tool which, at least, shows high resistance against flank wear and comb cracks, and also shows high edge line toughness.

### Definitions

By the term "average layer period thickness" is meant the average thickness of a combination A-B in the nano-multilayer coating of a first nanolayer A and second nanolayer B in a nano-multilayer A-B-A-B-A... To determine the average layer period thickness, a calculation can be made from a TEM analysis of a cross-section of the nano-multilayer counting the number of consecutive A-B nanolayer combinations over a length of at least 200 nm and calculating an average value. In some cases, if the deposition process is known, the calculation can be made by dividing the total thickness of the nano-multilayer by the number of A-B depositions.

### Detailed description of the invention

It has now been provided a nano-multilayered coating of alternating (Ti,Si,M)N and (Ti,AI,M)N layers having an improved flank wear resistance, superior edge line toughness and also a high comb crack resistance.

The present invention relates to a coated cutting tool comprising a substrate and a nano-multilayer coating, wherein the coating comprises
- a first layer stack and a second layer stack that is alternated at least twice, wherein
- the first layer stack comprising alternating nanolayers A and B wherein the average layer period thickness of A+B is between 15 and 50 nm,
- a second layer stack comprising alternating nanolayers A and B wherein the average layer period thickness of A+B is between 2 and 10 nm,

the composition of nanolayer A is (Ti_{1-a-b}AlₐM_{b})N where 0.5≤a≤0.75, 0≤b≤0.10 and M is one or more elements selected from Cr, Zr, Nb, Mo, Ta and V.
the composition of nanolayer B is (Ti_{1-c-d}Si_{c}M_{d})N where 0.10≤c≤ 0.25, 0≤d≤0.10 and M is one or more elements selected from Cr, Zr, Nb, Mo, Ta and V.

In the first layer stack comprising alternating nanolayers A and B, the average layer period thickness of A+B is between 15 and 50 nm, preferably between 18 and 35 nm.

In the second layer stack comprising alternating nanolayers A and B, the average layer period thickness of A+B is between 2 and 10 nm, preferably between 3 and 8 nm.

The thickness of the first and second layer stack can be the same or different from each other. The thickness of the different first layer stacks in the nano-multilayer coating can either be the same for all first layer stacks or different. The same is valid for the thickness of the different second layer stacks which also can be the same or different. Suitably, the thickness is between 50 and 1000 nm, preferably between 100 and 500 nm. The total number of stacks alternating, i.e. total sum of both first and second layer stacks, is at least 4, preferably between 6 and 50, more preferably between 8 and 30.

In one embodiment of the present invention, the composition of the nanolayer A (Ti_{1-a-b}AlₐM_{b})N is preferably 0.55≤a≤0.7, 0 ≤b≤0.10.

In one embodiment of the present invention, the composition of the first nanolayer A (Ti₁-ₐ-_{b}AlₐM_{b})N is preferably 0.55≤a≤0.7, 0 ≤b≤0.05.

In one embodiment of the present invention, the element M in nano layer A is Cr.

In one embodiment of the present invention, the composition of the first nanolayer A (Ti₁-ₐ-_{b}AlₐM_{b})N is preferably 0.55≤a≤0.7 and b=0.

In one embodiment of the present invention, the composition of the nanolayer B (Ti_{1-c-d}Si_{c}M_{d})Nis preferably 0.15≤c≤0.22 and 0≤d≤0.10.

In one embodiment of the present invention, the composition of the nanolayer B (Ti_{1-c-d}Si_{c}M_{d})Nis preferably 0.15≤c≤0.22 and 0≤d≤0.05.

In one embodiment of the present invention, the element M in nanolayer B is Cr.

In one embodiment of the present invention, the composition of the nanolayer B (Ti_{1-c-d}Si_{c}M_{d})N is preferably 0.15≤c≤0.22 and d=0.

In one embodiment of the present invention, the nano-multilayer coating comprises a starting layer, between said substrate and the alternating first and second layer stacks. The starting layer has a thickness of between 0.2 and 2 µm, preferably between 0.5 and 1.5 µm. The composition is (Ti₁-ₐ-_{b}AlₐM_{b})N where 0.5≤a≤0.75, 0≤b≤0.10 and M is one or more elements selected from Cr, Zr, Nb, Mo, Ta and V. Preferably 0.55≤a≤0.7, 0≤b≤0.10, more preferably 0.55≤a≤0.7 and b=0.

In one embodiment of the present invention, the composition of starting layer is the same as that of nanolayer A.

The total thickness of the coating is between 1 and 10 µm, preferably between 1 and 7 µm, more preferably between 2 and 4 µm.

The nano-multilayer coating is suitably deposited using a PVD process, preferably any of cathodic arc evaporation, magnetron sputtering or HIPIMS, more preferably cathodic arc evaporation.

The substrate of the coated cutting tool can be selected from the group of cemented carbide, cermet, ceramic, cubic boron nitride and high speed steel. In one embodiment the substrate is a cemented carbide comprising from 5 to 18 wt% Co and from 0 to 10 wt% carbides, nitrides or carbonitrides of one or more elements of group 4 to 5 in the periodic table of elements.

Further components like Cr are possible in a cemented carbide substrate.

The coated cutting tool is suitably a cutting tool insert, a drill, or a solid end-mill, for metal machining. The cutting tool insert is, for example, a turning insert or a milling insert.

### Description of drawings

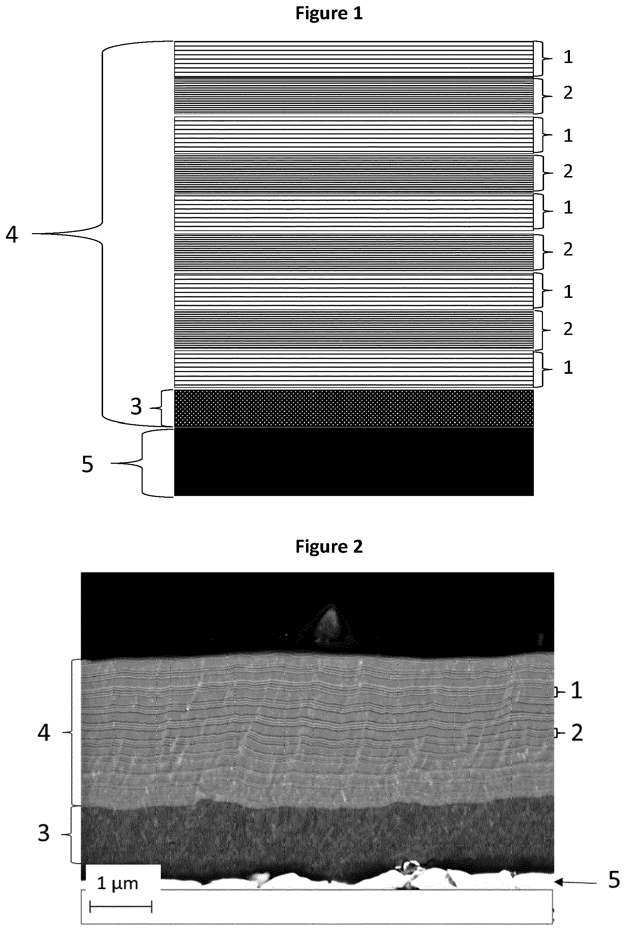

Figure 1 is a schematic drawing of the nano-multilayer coating where 1 and 2 show the alternating first layer and second layer stacks, 3 is the starting layer, 4 is the nano layered coating and 5 is the substrate.
Figure 2 shows a Scanning Electron Microscope (SEM) image of a coating according to the invention where 1 and 2 show the alternating first layer and second layer stacks, 3 is the starting layer, 4 is the nano layered coating and 5 is the substrate.

### Example 1 (Invention)

Different nano-multilayers of (Ti,Si)N and (Ti,AI)N were deposited on sintered cemented carbide cutting tool insert blanks of the geometries CNMG120408MM and R390-11. The composition of the cemented carbide was 10 wt% Co, 0.4 wt% Cr and rest WC. The cemented carbide blanks were coated by cathodic arc evaporation in a vacuum chamber comprising four arc flanges. Targets of Ti-Si were mounted in two of the flanges opposite each other. Targets of Ti-AI were mounted in the two remaining flanges opposite each other. The targets were circular and planar with a diameter of 100 mm available on the open market. Suitable target technology packages for arc evaporation are available from suppliers on the market such as IHI Hauzer Techno Coating B.V., Kobelco (Kobe Steel Ltd.) and Oerlikon Balzers.

The uncoated blanks were mounted on pins that undergo a three-fold rotation in the PVD chamber.

The chamber was pumped down to high vacuum (less than 10⁻² Pa) and heated to 450-550°C by heaters located inside the chamber. The blanks were then etched for 60 minutes in an Ar plasma.

A Ti_{0.33}Al_{0.67}N starting layer, being the same for all multi-nano layers, with a thickness of 1 µm was deposited at 10Pa and 300V.

On top of the starting layer, a nano-multilayer coating having a thickness of about 2 µm was then deposited.

The chamber pressure (reaction pressure) was set to 4 Pa of N₂ gas, and a DC bias voltage of -50 V (relative to the chamber walls) was applied to the blank assembly. The cathodes were run in an arc discharge mode at a current of 150 A (each) for 75 minutes (4 flanges).

Depositions were made with Ti-Si targets being Ti_{0.80}Si_{0.20} and Ti-AI targets being Ti_{0.33}Al_{0.67} was used for Invention 1 and Comparative 1 and 2. For Comparative 3 Ti_{0.33}Al_{0.67} and Ti_{0.50}Al_{0.50} was used. The rotational speed correlates to a certain period thickness. In order to investigate the effect of alternating first and second layers stacks with different period thickness in the nano-multilayer a series of depositions of blanks were made using different table rotational speeds.

The rotational speed, the estimated average nano layer period thickness and the layer stack thickness are given in Table 1.

The total thickness of the nano-multilayer coating on the rake and flank face was measured on a polished cross section of the insert, approx. 200 µm from the cutting edge using a Light Optical Microscope (LOM). The results are given in Table 2.

**Table 1**

| | | First layer stack | | | Second layer stack | | |
|---|---|---|---|---|---|---|---|
| | No of alt. 1^{st}/2^{nd} layer stacks | Rot. Speed (rpm) | Average nanolayer period thickness (nm) | Layer stack (nm) | Rot. Speed (rpm) | Average nanolaye r period thickness (nm) | Layer stack (nm) |
| Invention 1 | 10 | 5 | 5 | 100 | 1 | 25 | 100 |
| Comparative 1 | - | 1 | 25 | 2000 | - | - | - |
| Comparative 2 | 4 | 2.4 | 130 | 260 | 5 | 5 | 250 |
| Comparative 3 | 10 | 5 | 5 | 100 | 1 | 25 | 100 |

**Table 2**

| | Thickness rake face (µm) | Thickness flank face (µm) |
|---|---|---|
| Invention 1 | 2.3 | 3.2 |
| Comparative 1 | 2.1 | 3.0 |
| Comparative 2 | 2.2 | 3.1 |
| Comparative 3 | 2.5 | 3.2 |

### Example 2 (working example)

A cutting test to investigate the different coatings with regard to resistance against edge line toughness was made with the following settings:

| Operation: | Shoulder Milling |
|---|---|
| Work piece material: | Dievar unhardened, P3. 0.Z.AN |
| Number of teeth: | z=1 |
| Cutting speed: | V_{c}=215 m/min |
| Feed rate: | f_{z}=0.15 mm |
| Radial engagement: | aₑ=12 mm |
| Depth of cut: | aₚ=3.0 |
| length of cut=12mm | |
| without cutting fluid | |

The cut-off criteria are chipping of at least 0.5 mm of the edge line or a measured depth of 0.2 mm at either the flank- or the rake phase. Tool life is presented as the number of cut entrances in order to achieve these criteria.

The results are shown in Table 3 and each result is an average of 8 tests.

**Table3**

| Sample | Tool life (no. of cuts) |
|---|---|
| Invention 1 | 44 |
| Comparative 1 | 17 |
| Comparative 2 | 19 |
| Comparative 3 | 24 |

### Example 3 (working example)

A cutting test to investigate the different coatings with regard to resistance against flank wear was made with the following settings:

| Operation: | Longitudinal turning |
|---|---|
| Work piece material: | Sverker 21 (tool steel), Hardness ~210HB, D=180, |
| | L=700 mm |
| Cutting speed: | V_{c}=125 m/min |
| Feed rate: | fₙ=0.072 mm/rev |
| Depth of cut: | aₚ=2 mm |
| without cutting fluid | |

The cut-off criteria for tool life is a flank wear VB of 0.15 mm.

The results are shown in Table 4 and each result is an average of 2 tests.

**Table 4**

| Sample | Tool life (min) |
|---|---|
| Invention 1 | 19.3 |
| Comparative 1 | 11.3 |
| Comparative 2 | 10.3 |
| Comparative 3 | 10.5 |

### Example 4 (working example)

A cutting test to investigate the different coatings with regard to resistance against comb cracks was made with the following settings:

| Operation: | Shoulder milling |
|---|---|
| Tool holder: | R390-11, 25 mm |
| Work piece material: | Toolox 33 (tool steel), L=600 mm, I=200 mm, h=100 mm, |
| Insert type: | R390-11 |
| Cutting speed: | V_{c}=275 m/min |
| Feed rate: | f_{z}=0.2 mm/rev |
| Feed per tooth | z=1 |
| Depth of cut: | aₚ=3 mm |
| Radial engagement: | aₑ= 12.5 mm |
| with cutting fluid | |

The criteria for end of tool life is a max. chipped height VB>0.3 mm.

The results are shown in Table 5 and each result is an average of 4 tests.

**Table 5**

| Sample | Tool life (No. of cuts) |
|---|---|
| Invention 1 | 30.2 |
| Comparative 1 | 23.2 |
| Comparative 2 | 29.0 |
| Comparative 3 | 24.1 |

## Claims

1. A coated cutting tool comprising a substrate and a nano-multilayer coating wherein the coating comprises
- a first layer stack and a second layer that stack is alternated at least twice, wherein
- the first layer stack comprising alternating nanolayers A and B wherein the average layer period thickness of A+B is between 15 and 50 nm,
- a second layer stack comprising alternating nanolayers A and B wherein the average thickness of layer A+B is between 2 and 10 nm,
the composition of nanolayer A is (Ti₁-ₐ-_{b}AlₐM_{b})N where 0.5 ≤a≤0.75, 0 ≤b≤0.10 and M is one or more elements selected from Cr, Zr, Nb, Mo, Ta and V,
the composition of nanolayer B is (Ti_{1-c-d}Si_{c}M_{d})N where 0.10 ≤c≤ 0.25, 0 ≤d≤ 0.10 and M is one or more elements selected from Cr, Zr, Nb, Mo, Ta and V.

2. A coated cutting tool according to claim 1 wherein in the first layer stack, the average layer period thickness of A+B is between 18 and 35 nm.

3. A coated cutting tool according to any of the preceding claims wherein in the second layer stack the average layer period thickness of A+B is between 3 and 8 nm.

4. A coated cutting tool according to any of the preceding claims wherein, for the first nanolayer A (Ti_{1-a-b}AlₐM_{b})N, 0.55≤a≤0.7, 0 ≤b≤0.10 and M is Cr.

5. A coated cutting tool according to any of the preceding claims wherein, for the first nanolayer B (Ti_{1-c-d}Si_{c}M_{d})N, 0.15≤c≤0.22, 0 ≤d≤0.10 and M is Cr.

6. A coated cutting tool according to any of the preceding claims wherein, for the first nanolayer A (Ti_{1-a-b}AlₐM_{b})N, 0.55≤a≤0.7, and b=0.

7. A coated cutting tool according to any of the preceding claims wherein, for the first nanolayer B (Ti_{1-c-d}Si_{c}M_{d})N, 0.15≤c≤0.22 and d=0.

8. A coated cutting tool according to any of the preceding claims wherein the number of alternating stacks, i.e. total sum of both first and second layer stacks, is at least 4, preferably between 6 and 50.

9. A coated cutting tool according to any of the preceding claims wherein the coating comprises a starting layer, between said substrate and the alternating first and second layer stacks, with a thickness of between 0.2 and 2 µm.

10. A coated cutting tool according to any of the preceding claims wherein the total thickness of the coating is between 1 and 10 µm.
